# EUROPÄISCHE PATENTSCHRIFT

(11) **EP 0 444 233 B1**
(45) Veröffentlichungstag und Bekanntmachung des Hinweises auf die Patenterteilung: **09.11.1994**
(21) Anmeldenummer: 90104106.1
(22) Anmeldetag: 02.03.1990
(51) Int. Cl.: H03M 1/18, H03M 1/06, H03M 1/20

(54) **Verfahren und Vorrichtung zur Analog/Digital-Wandlung eines sich zeitlich ändernden analogen Eingangssignals**
Method and device for the analogue/digital conversion of a time-variant analogue input signal
Procédé et dispositif de conversion analogique/numérique d'un signal d'entrée analogique variant dans le temps

(43) Veröffentlichungstag der Anmeldung: 04.09.1991
(73) Patentinhaber: Siemens-Elema AB, 171 95 Solna 1 (SE); SIEMENS AKTIENGESELLSCHAFT, 80333 München (DE)
(72) Erfinder: Hjorth, Bo, S-191 43 Sollentuna (SE); Ohlsson, Thomas, Dipl.-Ing, S-162 43 Vällingby (SE)

(56) Entgegenhaltungen:
- US-A- 4 851 842

## Beschreibung

Die Erfindung betrifft ein Verfahren und eine Vorrichtung zur Analog/Digital-Wandlung eines sich zeitlich ändernden analogen elektrischen Eingangssignals.

Es sind derzeit als integrierte Schaltungen ausgeführte Analog/Digital-Wandler verfügbar, die z.B. nach dem sogenannten "Dual Slope"-Verfahren arbeiten und die Analog/Digital-Wandlung eines sich zeitlich ändernden analogen elektrischen Eingangssignals mit einer Auflösung von bis zu 16 bit gestatten. Sollen derartige Analog/Digital-Wandler, wie dies z.B. im Falle der Elektrokardiographie (EKG) oder der Elektroencephalographie (EEG) erforderlich ist, derart betrieben werden, daß der kleinste erfaßbare Spannungsunterschied des zu messenden Signals, der einem least significant bit (LSB) der Analog/Digital-Wandlung entspricht, in der Größenordnung von einigen Mikrovolt liegt, ergibt sich nur ein sehr eingeschränkter Dynamikbereich für das zu messende Signal, was zur Folge hat, daß der Analog/Digital-Wandler sehr rasch durch das zu messende Signal übersteuert wird. Dies ist im Falle der Elektrokardiographie, wo auch unmittelbar nach einer Defibrillation, dabei wird das Herz eines Patienten mit Impulsen relativ hoher Spannung und Stromstärke beaufschlagt, die Aufzeichnung eines Elektroardiogramms möglich sein soll, in höchstem Maße unerwünscht. Eine denkbare Abhilfe wäre hier die Verwendung von Analog/Digital-Wandlern mit höherer Auflösung (bit-Anzahl). Während jedoch bereits die Verwendung eines als integrierte Schaltung ausgeführten Analog/Digital-Wandlers der erwähnten Auflösung mit erheblichen Kosten verbunden ist, würde dies die Verwendung eines diskret aufgebauten Analog/Digital-Wandlers erfordern, was einen ganz beträchtlichen technischen und finanziellen Aufwand nach sich ziehen würde. Dieser Aufwand kann wenigstens zum Teil vermieden werden, wenn von dem sogenannten DAC-Feed Back-Verfahren Gebrauch gemacht wird. Dabei wird anhand der einer elektronischen Recheneinrichtung zugeführten digitalen Ausgangssignale des verwendeten Analog/Digital-Wandlers ein mit der elektronischen Recheneinrichtung verbundener Digital/Analog-Wandler von der elektronischen Recheneinrichtung derart angesteuert, daß er ein analoges Ausgangssignal erzeugt, das mittels eines Differenzverstärkers von dem zu messenden Signal subtrahiert wird. Dabei wird der Digital/Analog-Wandler mittels der elektronischen Recheneinrichtung in Abhängigkeit von der momentanen Amplitude des zu messenden Signals jeweils derart angesteuert, daß das Ausgangssignal des Differenzverstärkers, das dem Analog/Digital-Wandler zugeführt ist, dessen Dynamikbereich nicht überschreitet. Die dem Ausgangssignal des Differenzverstärkers entsprechenden digitalen Daten werden anschließend korrigiert, indem die elektronische Recheneinrichtung zu diesen den jeweils entsprechenden Wert des Ausgangssignals des Digital/Analog-Wandlers addiert. Exakte Ergebnisse werden mit diesem Verfahren jedoch nur dann erhalten, wenn die Auflösung (bit-Anzahl) des Digital/Analog-Wandlers der angestrebten Auflösung der Analog/Digital-Wandlung entspricht. Da jedoch bei Digital/Analog-Wandlern ähnliche Probleme auftreten, wie sie bereits im Zusammenhang mit Analog/Digital-Wandlern beschrieben wurden, finden in der Regel Digital-Analog-Wandler Verwendung, deren Auflösung geringer als die angestrebte Auflösung der Analog/Digital-Wandlung ist. Dies führt zu Ungenauigkeiten. So enthalten die Ergebnisse der Analog/Digital-Wandlung z.B. Sprünge, die in dem analogen Eingangssignal in dieser Weise nicht vorhanden sind. Ein weiterer Nachteil des beschriebenen Verfahrens liegt in der Notwendigkeit eines zusätzlichen Digital/Analog-Wandlers, der zusätzliche Kosten verursacht.

Der Erfindung liegt die Aufgabe zugrunde, ein Verfahren und eine Einrichtung zur Analog/Digital-Wandlung eines sich zeitlich ändernden analogen elektrischen Eingangssignals anzugeben, die technisch einfach und kostengünstig sind, einen großen Dynamikumfang aufweisen und gleichzeitig die Messung sehr kleiner Spannungsänderungen gestatten, und insbesondere zur Analog/Digital-Wandlung elektrokardiographischer Signale geeignet sind.

Der das Verfahren betreffende Teil der Aufgabe wird gemäß der Erfindung durch das Verfahren nach dem Patentanspruch 1 gelöst. Demnach stehen also zum einen digitale Daten, die dem aufbereiteten Signal entsprechen, und zum anderen digitale Daten zur Verfügung, die dem Eingangssignal einschließlich etwaiger durch die Anwendung der Übertragungsfunktion im aufbereiteten Signal nicht vorhandener Signalanteile entsprechen. Dabei entspricht bei der Analog/Digital-Wandlung des aufbereiteten Signals infolge der bei der Aufbereitung des Eingangssignals unter anderem vorgenommenen Verstärkung mit dem definierten Faktor eine Änderung des Resultats der Analog/Digital-Wandlung um ein LSB einer Spannungsänderung des Eingangssignals, die sich aus der Division des einem LSB entsprechenden Spannungsunterschiedes durch den definierten Verstärkungsfaktor ergibt. Wird also das Ergebnis der Analog/Digital-Wandlung unter Heranziehung der dem aufbereiteten Signal entsprechenden digitalen Daten ermittelt, sind die meßbaren Spannungsunterschiede infolge der Verstärkung kleiner als im Falle der Ermittlung des Ergebnisses der Analog/Digital-Wandlung auf Grundlage der dem unverstärkten Eingangssignal entsprechenden digitalen Daten. Allerdings tritt bezüglich des aufbereiteten Signals eine dem definierten Verstärkungsfaktor entsprechende Verringerung des Dynamikbereiches auf. Wenn also die in dem Eingangssignal enthaltenen Signalanteile, die durch die Anwendung der Übertragungsfunktion aus dem aufbereiteten Signal entfernt wurden, von untergeordnetem Interesse sind, kann im einfachsten Falle so vorgegangen werden, daß als Ergebnis der Analog/Digital-Wandlung die dem aufbereiteten Signal entsprechenden digitalen Daten verwendet werden und die dem Eingangssignal entsprechenden digitalen Daten nur dann an deren Stelle treten, wenn entweder bei der Analog/Digital-Wandlung des aufbereiteten Signals eine Überschreitung des Dynamikbereiches auftritt oder die in dem Eingangssignal zusätzlich enthaltenen Signalanteile von Interesse sind. Es wird somit deutlich, daß es das erfindungsgemäße Verfahren auf technisch einfache und kostengünstige Weise gestattet, bei einer Analog/Digital-Wandlung mit einer gegebenen bit-Anzahl der resultierenden digitalen Daten gleichzeitig einen hohen Dynamikbereich zu realisieren und sehr kleine Spannungsänderungen zu messen. Dabei sind die dem Eingangssignal und die dem aufbereiteten Signal entsprechenden digitalen Daten infolge der Multiplikation der dem Eingangssignal entsprechenden digitalen Daten mit einem dem definierten Verstärkungsfaktor entsprechenden Faktor direkt miteinander vergleichbar, wenn man davon absieht, daß in dem Eingangssignal möglicherweise Signalanteile enthalten sind, die das aufbereitete Signal nicht enthält.

Eine insbesondere für die Elektrokardiographie vorteilhafte Variante der Erfindung ist in dem Patentanspruch 2 angegeben. Infolge des Umstandes, daß als erste Übertragungsfunktion die Übertragungsfunktion eines Hochpasses angewendet wird, ist nämlich gewährleistet, daß das aufbereitete Signal auch nach einer Defibrillation den dynamischen Anteil des Signals korrekt wiedergibt, ohne daß Überschreitungen des Dynamikbereiches auftreten, da diejenigen Signalanteile des Eingangssignals ausgefiltert sind, die der durch die Defibrillation bewirkten Gewebepolarisation entsprechen.

Eine besonders vorteilhafte Variante der Erfindung ist in dem Patentanspruch 6 angegeben. Infolge des Umstandes, daß auf die mit dem definierten Faktor multiplizierten, dem Eingangssignal entsprechenden digitalen Daten durch digitales Filtern, als dritte Übertragungsfunktion das komplexe Komplement der ersten Übertragungsfunktion angewendet wird, entsprechen die nach dem digitalen Filtern vorliegenden digitalen Daten der Differenz zwischen den zeitlichen Verläufen des Eingangssignals und des aufbereiteten Signals. In diesem Zusammenhang wird bezüglich weiterer Informationen auf das Buch "Theory and Application of Digital Signal Processing" von L.R. Rabiner und B. Gold, Prentice-Hall, Inc., New Jersey, ISBN 0-13-914 101-4, verwiesen. Dabei erfolgt durch das digitale Filtern sozusagen eine "Interpolation" zwischen den durch ein LSB voneinander getrennten dem Eingangssignal entsprechenden Daten. Wenn man also zu den dem aufbereiteten Signal entsprechenden digitalen Daten in zeitlich korrekter Zuordnung jeweils die durch das digitale Filtern des Eingangssignals erhaltenen digitalen Daten addiert, erhält man als Summe digitale Daten, deren bit-Anzahl infolge der bei dem digitalen Filtern vorgenommenen "Interpolation" höher als die bit-Anzahl der Analog/Digital-Wandlung ist, und zwar zweckmäßigerweise um ein Maß, das dem definierten Verstärkungsfaktor entspricht. Es ergibt sich dann z.B. im Falle eines definierten Verstärkungsfaktors von 32 eine Erhöhung der bit-Anzahl um 5 bit, während ein definierter Verstärkungsfaktor von 64 eine Erhöhung um 6 bit ergeben würde. Solange bei der Analog/Digitalwandlung des aufbereiteten Signals keine Überschreitungen des Dynamikbereiches auftreten, werden also als Ergebnis der Analog/Digital-Wandlung digitale Daten erhalten, deren bit-Anzahl höher als die bit-Anzahl der Analog/Digital-Wandlung ist. Dabei ist wesentlich, daß die in der beschriebenen Weise erhaltenen digitalen Daten auch diejenigen Signalanteile umfassen, die bei der Bildung des aufbereiteten Signals durch die Anwendung der ersten Übertragungsfunktion entfernt werden. Nur dann, wenn bei der Analog/Digital-Wandlung des aufbereiteten Signals eine Überschreitung des Dynamikbereiches auftritt, müssen als Ergebnis der Analog/Digital-Wandlung in der bereits beschriebenen Weise digitale Daten herangezogen werden, deren bit-Anzahl auf die der Analog/Digital-Wandlung beschränkt ist.

Auch diese Beschränkung entfällt, wenn von einer weiteren besonders vorteilhaften Ausführungsform der Erfindung Gebrauch gemacht wird, die im Patentanspruch 9 angegeben ist. In diesem Falle erhält man ohne Berücksichtigung der dem aufbereiteten Signal entsprechenden digitalen Daten als Ergebnis der Analog/Digital-Wandlung des Eingangssignals digitale Daten, deren bit-Anzahl höher als die bit-Anzahl der Analog/Digital-Wandlung ist. Dies hat seinen Grund wieder darin, daß bei der durch digitales Filtern erfolgenden Anwendung der integrierenden Übertragungsfunktion zwischen um 1 LSB voneinander getrennten, dem Eingangssignal entsprechenden, mit dem definierten Faktor multiplizierten digitalen Daten eine "Interpolation" erfolgt. Vorzugsweise wird die Zeitkonstante der Integration derart gewählt, daß die Integration jeweils eine Anzahl von digitalen Daten umfaßt, die dem definierten Verstärkungsfaktor entspricht. Diejenigen digitalen Daten, die dann als dem Eingangssignal entsprechende digitale Daten verwendet werden, besitzen dann bei einem Verstärkungsfaktor von beispielsweise 32 eine bit-Anzahl, die um 5 bit höher als die bit-Anzahl der Analog/Digital-Wandlung ist. Bei dem analogen elektrischen Signal kann es sich beispielsweise um ein periodisches Signal, z.B. ein Sägezahnsignal, oder ein nicht periodisches Signal, z.B. Rauschen, handeln. Wesentlich ist nur, daß das Signal eine statistisch gleichmäßige Amplitudenverteilung besitzt.

Der die Einrichtung betreffende Teil der Aufgabe wird durch die im Patentanspruch 12 angegebene Einrichtung gelöst, deren Wirkungsweise und Vorteile sich aus der vorangegangenen Beschreibung des erfindungsgemäßen Verfahrens ergeben.

Die im Patentanspruch 23 angegebene erfindungsgemäße Einrichtung liefert als Ergebnisse des Vergleiches digitale Daten, die es gestatten, den definierten Verstärkungsfaktor und den definierten Faktor einander genau anzugleichen sowie gegebenenfalls eine Abstimmung der dritten Übertragungsfunktion auf die erste Übertragungsfunktion in dem Sinne vorzunehmen, daß die dritte Übertragungsfunktion tatsächlich das komplexe Komplement der ersten Übertragungsfunktion darstellt.

Weitere Vorteile der Erfindung ergeben sich anhand der Beschreibung eines in den beigefügten Figuren dargestellten Ausführungsbeispieles. Es zeigen:
- Fig. 1: in schematischer Darstellung ein Blockschaltbild einer erfindungsgemäßen Einrichtung zur Analog/Digital-Wandlung,
- Fig. 2 bis 5: Analog-Schaltungen zur Veranschaulichung unterschiedlicher Betriebs weisen der Einrichtung gemäß Fig. 1, und
- Fig. 6: ein Diagramm zur Veranschaulichung einer weiteren Betriebsart des erfindungsgemäßen Gerätes.

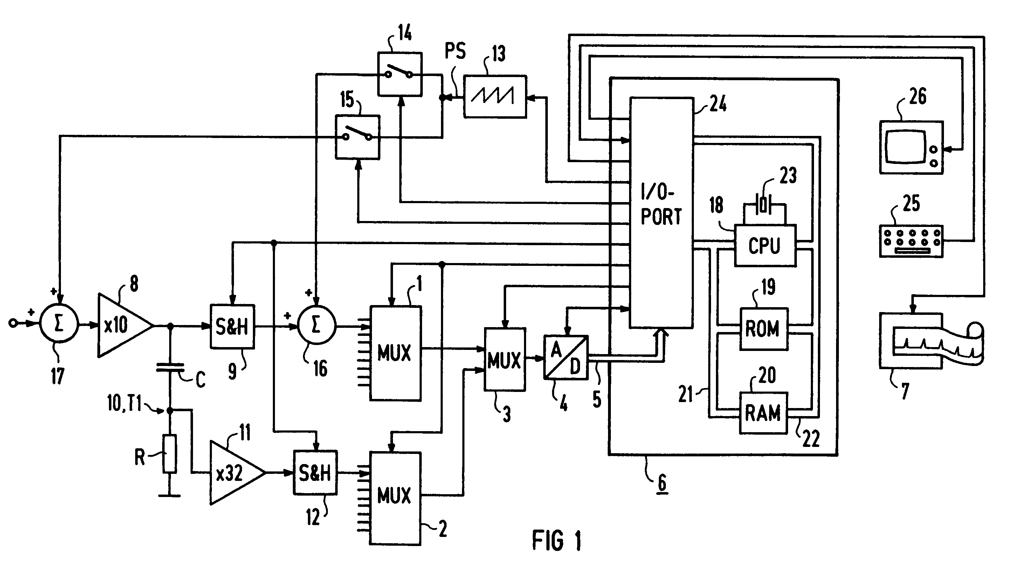

In der Fig. 1 ist eine erfindungsgemäße Einrichtung dargestellt, die Bestandteil einer Einrichtung zur Verarbeitung und Aufzeichnung von elektrokardiographischen Signalen ist. Dabei ist ein erster 9:1-Kanal Analog-Multiplexer 1 vorgesehen. Jedem von dessen Eingängen ist eine der üblicherweise 9 (3 Extremitäten- und 6 Brustableitungen) EKG-Ableitungen zugeordnet. Parallel zu dem ersten Multiplexer 1 liegt ein zweiter Multiplexer 2, der ebenfalls als 9:1-Kanal Analog-Multiplexer ausgeführt ist und dessen Zweck im weiteren deutlich werden wird. Die Ausgänge der beiden Multiplexer 1 und 2 sind mit den Eingängen eines 2:1-Kanals Analog-Multiplexers 3 verbunden, dessen Ausgangssignal dem Eingang eines Analog/Digital-Wandlers 4 zugeführt ist, bei dem es sich um einen 14-bit-Wandler handelt. Die digitalen Ausgangsdaten des Analog/Digital-Wandlers 4 gelangen über einen Datenbus 5 zu einer elektronischen Recheneinrichtung 6, in der sie weiterverarbeitet werden. An die elektronische Recheneinrichtung 6 ist ein Aufzeichnungsgerät 7 angeschlossen, bei dem es sich, wie in der Fig. 1 schematisch angedeutet ist, um einen mittels der elektronischen Recheneinrichtung 6 ansteuerbaren EKG-Schreiber handelt.

Die den einzelnen EKG-Ableitungen entsprechenden Signale gelangen nicht unmittelbar zu dem ihnen jeweils zugeordneten Eingang des ersten Multiplexers 1. Sie durchlaufen vielmehr, wie dies in der Fig. 1 am Beispiel eines Kanals dargestellt ist, einen Verstärker 8, der im Falle des dargestellten Ausführungsbeispieles einen Verstärkungsfaktor von 10 aufweist. Das Ausgangssignal des Verstärkers 8 ist einer Sample and Hold-Schaltung 9 zugeführt, deren Ausgang mit einem Eingang des ersten Multiplexers 1 verbunden ist. Das Ausgangssignal des Verstärkers 8 ist außerdem einem durch einen Kondensator C und einen Widerstand R gebildeten, mit 10 bezeichneten Hochpaß erster Ordnung zugeführt, der dazu dient, auf das ihm zugeführte Signal eine erste Übertragungsfunktion T1 anzuwenden, bei der es sich selbstverständlich um die des Hochpasses 10 selbst handelt. Die Grenzfrequenz des Hochpasses 10 ist ausreichend niedrig gewählt, um die Unterdrückung von diagnostisch relevanten tieffrequenten Anteilen des Eingangssignals zu vermeiden. Das Ausgangssignal des Hochpasses 10 gelangt zu einem zweiten Verstärker 11, der dieses mit einem definierten Verstärkungsfaktor V, im Falle des dargestellten Ausführungsbeispiels V = 32, verstärkt. Das Ausgangssignal des zweiten Verstärkers 11 ist einer zweiten Sample and Hold-Schaltung 12 zugeführt, deren Ausgang mit einem der Eingänge des zweiten Multiplexers 2 verbunden ist, und zwar mit demjenigen Eingang, der dem mit der zu dem jeweiligen Kanal gehörigen ersten Sample and Hold-Schaltung 9 verbundenen Eingang des ersten Multiplexers 1 entspricht. Im Falle des dargestellten Ausführungsbeispieles sind die Sample and Hold-Schaltungen 9 und 12 jeweils mit dem zweiten Eingang (von oben gezählt) des Multiplexers 1 bzw. 2 verbunden. Die Sample and Hold-Schaltungen 9 und 12 können auch entfallen, falls sichergestellt ist, daß die Folgefrequenz der Analog/Digital-Wandlungen für jeden Kanal der Einrichtung deutlich oberhalb der höchsten interessierenden Signalfrequenz bzw. der oberen Grenzfrequenz des zugeführten Signals liegt.

Im folgenden wird das der ersten Sample and Hold-Schaltung 9 zugeführte Signal ungeachtet dessen, daß es zuvor mittels des Verstärkers 8 verstärkt wird, als Eingangssignal ES bezeichnet, während das aus dem Eingangssignal ES durch Entfernung von dessen Gleichspannungsanteilen mittels des Hochpasses 10 und durch Verstärkung um den definierten Verstärkungsfaktor V mittels des Verstärkers 11 gewonnene und der zweiten Sample and Hold-Schaltung 12 zugeführte Signal als aufbereitetes Signal AS bezeichnet wird.

Sowohl die Multiplexer 1, 2 und 3 als auch die Sample and Hold-Schaltungen 9 und 12 sind über Steuerleitungen mit der elektronischen Recheneinrichtung 6 verbunden, von der sie ihre Steuersignale erhalten. Dabei erfolgt die Ansteuerung der beiden Multiplexer 1 und 2 über eine gemeinsame Steuerleitung derart, daß jeweils die einzelnen Eingänge periodisch aufeinanderfolgend mit dem Ausgang verbunden werden, wobei sich dieser Vorgang zyklisch wiederholt. Während desjenigen Zeitintervalls, für das die zu einer bestimmten EKG-Ableitung gehörigen Eingänge der Multiplexer 1 und 2 mit deren jeweiligem Ausgang verbunden sind, führt die elektronische Recheneinrichtung 6 der jeweiligen Sample and Hold-Schaltung 9 bzw. 12 über die gemeinsame Steuerleitung ein Sperrsignal zu, durch das gewährleistet ist, daß sich die an den jeweiligen Eingängen der Multiplexer 1 und 2 anliegende Spannung während des genannten Zeitintervalls nicht ändert. Den Multiplexer 3 steuert die elektronische Recheneinrichtung 6 derart, daß dieser für die eine Hälfte des genannten Zeitintervalls den Ausgang des Multiplexers 1 und für die andere Hälfte des genannten Zeitintervalls den Ausgang des Multiplexers 2 mit dem Eingang des Analog/Digital-Wandlers 4 verbindet. Dabei ist das genannte Zeitintervall ausreichend lang gewählt, um den Analog/Digital-Wandler 4 während der Hälften dieses Zeitintervalls jeweils die Vornahme einer Analog/Digital-Wandlung zu ermöglichen. Der Analog/Digital-Wandler 4 ist über eine Leitung mit der elektronischen Recheneinrichtung 6 verbunden, über die diese dem Analog/Digital-Wandler 4 jeweils zum geeigneten Zeitpunkt einen Impuls zuführt, der den Beginn einer Analog/Digital-Wandlung einleitet. Umgekehrt gibt der Analog/Digital-Wandler 4 über die gleiche Leitung ein Signal an die elektronische Recheneinrichtung 6 ab, wenn er eine Analog/Digital-Wandlung abgeschlossen hat. Dabei gibt die elektronische Recheneinrichtung 6 im Falle des beschriebenen Ausführungsbeispieles die eine Analog/Digital-Wandlung einleitenden Impulse mit einer derartigen Folgefrequenz ab, daß Aliasing-Effekte vermieden sind. Es wird also deutlich, daß der Analog/Digital-Wandler 4 der elektronischen Recheneinrichtung 6 einen Strom digitaler Daten zuführt, der bei der abwechselnden, quasi-gleichzeitigen Analog/Digital-Wandlung des Eingangssignals ES bzw. des aufbereiteten Signals AS der den einzelnen Kanälen entsprechenden EK-Ableitungen erhalten wird, wobei die digitalen Daten jeweils die gleiche bit-Anzahl von 14 bit aufweisen.

Gemäß Fig. 1 ist außerdem ein Signalgenerator 13 vorhanden, der ein periodisches Signal PS mit einer statistisch gleichmäßigen Amplitudenverteilung, z.B. ein Sägezahnsignal, erzeugt. Das mittels des Signalgenerators 13 erzeugte periodische Signal PS ist über zwei elektronische Schalter 14, 15, die über entsprechende Steuerleitungen durch die elektronische Recheneinrichtung 6 betätigbar sind, Summierungspunkten 16 bzw. 17 zuführbar, die zwischen der Sample and Hold-Schaltung 9 und dem Multiplexer 1 bzw. vor dem Eingang des Verstärkers 8 liegen. Es besteht also die Möglichkeit, das mittels des Signalgenerators 13 erzeugte periodische Signal PS wahlweise den Samples des Eingangssignals ES oder dem dem Verstärker 8 zugeführten Signal zu überlagern. Die Frequenz des periodischen Signals PS ist vorzugsweise derart gewählt, daß seine Periodendauer derjenigen Zeit entspricht, die für eine dem definierten Verstärkungsfaktor V entsprechende Anzahl von Analog/Digital-Wandlungen jeweils zusammengehöriger Samples des Eingangssignals ES und des Ausgangssignals AS erforderlich ist. Um die erforderliche Synchronisation zu erreichen, ist der Signalgenerator 13 über eine Steuerleitung mit der elektronischen Recheneinrichtung 6 verbunden.

Die elektronische Recheneinrichtung 6 ist in an sich bekannter Weise aus einer Zentraleinheit (CPU) 18, einem Nur-Lese-Speicher (ROM) 19 und einem Schreib-Lese-Speicher (RAM) 20 aufgebaut, die über einen Adressbus 21 und einen Datenbus 22 miteinander verbunden sind. Das ROM 19 und das RAM 20 dienen zur Speicherung des Betriebssystems, des eigentlichen Programms sowie variabler Daten. An die CPU 18 ist ein Quarz 23 angeschlossen, der zur Erzeugung der zum Betrieb der elektronischen Recheneinrichtung 6 erforderlichen Taktsignale dient, aus denen auch die Steuersignale für die Multiplexer 1 bis 3, den Analog/Digital-Wandler 4, die Sample and Hold-Schaltungen 9 und 12 und den Signalgenerator 13 abgeleitet werden. Diese Signale gelangen über einen Eingangs-/Ausgangs-Schaltkreis (I/O-PORT) 24, der sowohl an den Adressbus 21 als auch an den Datenbus 22 angeschlossen ist, zu den genannten Komponenten. Auch der Datenbus 5, über den die digitalen Ausgangssignale des Analog/Digital-Wandlers 4 zu der elektronischen Recheneinrichtung 6 gelangen, ist an den I/O-PORT 24 angeschlossen. Weiter sind an diesen eine Tastatur 25, ein Datensichtgerät 26 und das bereits erwähnte Aufzeichnungsgerät 7 angeschlossen.

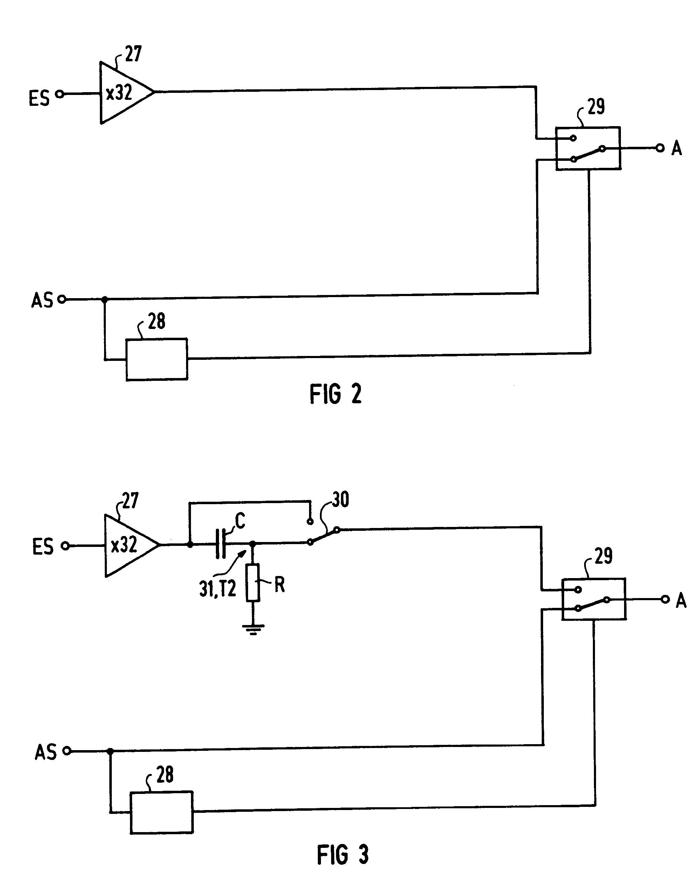

Mittels der elektronischen Recheneinrichtung 6 werden die den Eingangssignalen ES und den aufbereiteten Signalen AS entsprechenden digitalen Daten in einer solchen Weise verarbeitet, daß einerseits Eingangssignale ES unter voller Ausnutzung des Dynamikbereiches des Analog/Digital-Wandlers 4 gewandelt werden können und andererseits Spannungsänderungen des Eingangssignals ES kleiner sind als diejenige Spannungsänderung, die bei direkter Zufuhr des Eingangssignals ES zu dem Eingang des Analog/Digital-Wandlers 4 und ohne anschließende Verarbeitung der digitalen Ausgangsdaten des Analog/Digital-Wandlers 4 eine Änderung des Resultates der Analog/Digital-Wandlung um ein LSB bewirken würde. Dies wird im folgenden anhand eines Kanals der Einrichtung gemäß Fig. 1 erläutert, wobei auf in den Fig. 2 bis 5 dargestellte Analog-Schaltungen Bezug genommen wird, die dazu dienen, das von der elektronischen Recheneinrichtung 6 ausgeführte Programm, soweit es um die Verarbeitung der der elektronischen Recheneinrichtung 6 von dem Analog/Digital-Wandler 4 zugeführten Daten geht, zu verdeutlichen. Es wird darauf hingewiesen, daß die Fig. 2 bis 5 nur erklärenden Charakter haben und keinesfalls dahingehend mißverstanden werden dürfen, daß anstelle der als Digitalrechner ausgebildeten elektronischen Recheneinrichtung 6 auch ein Analogrechner Verwendung finden kann. Dies ist schon wegen der der elektronischen Recheneinrichtung 6 von dem Analog/Digital-Wandler 4 zugeführten digitalen Daten ausgeschlossen, die mittels eines Analogrechners nicht verarbeitet werden könnten.

Die dem Eingangssignal ES entsprechenden, von dem Analog/Digital-Wandler 4 gelieferten digitalen Daten, die durch die Analog/Digital-Wandlung des jeweiligen Ausgangssignals der Sample and Hold-Schaltung 9 erhalten werden, multipliziert die elektronische Recheneinrichtung 6 grundsätzlich jeweils mit einem definierten Faktor F, der dem definierten Verstärkungsfaktor V entspricht, mit dem das Ausgangssignal des Hochpasses 10 zur Gewinnung des aufbereiteten Signals AS verstärkt wird. Der definierte Faktor F beträgt im Falle des beschriebenen Ausführungsbeispieles demzufolge F = 32. Dies ist in Fig. 2 durch einen Verstärker 27 mit entsprechendem Verstärkungsfaktor angedeutet. Die dem aufbereiteten Signal AS entsprechenden, von dem Digital/Analog-Wandler 4 gelieferten digitalen Daten, die durch die Analog/Digital-Wandlung des jeweiligen Ausgangssignals der Sample and Hold-Schaltung 12 erhalten werden, überprüft die elektronische Recheneinrichtung 6 jeweils darauf hin, ob eine Überschreitung des Dynamikbereiches des Analog/Digital-Wandlers 4 vorliegt, was auf einfache Weise dadurch geschehen kann, daß die elektronische Recheneinrichtung 6 von einer Überschreitung des Dynamikbereiches ausgeht, wenn sämtliche bits der einem Sample des aufbereiteten Signals AS entsprechenden digitalen Daten den Wert logisch "1" besitzen. Falls der Analog/Digital-Wandler 4 ein Überschreiten des Dynamikbereiches anzeigendes Signal (overflow) abgibt, genügt es, wenn die elektronische Recheneinrichtung 6 dieses Signal überwacht. Im Falle der Fig. 2 ist die beschriebene Überprüfung dadurch symbolisiert, daß das aufbereitete Signal AS einer Detektorschaltung 28 zugeführt ist, die dann ein Ausgangssignal abgibt, wenn eine Überschreitung des Dynamikbereiches vorliegt.

Im einfachsten Fall berücksichtigt die elektronische Recheneinrichtung 6 die aus der Analog/Digital-Wandlung des aufbereiteten Signals AS gewonnenen digitalen Daten als Ergebnis der Analog/Digital-Wandlung, solange keine Überschreitung des Dynamikbereiches vorliegt, während sie im Falle einer Überschreitung des Dynamikbereiches für die Dauer der Überschreitung die aus der Anlaog/Digital-Wandlung des Eingangssignals ES gewonnenen mit dem definierten Faktor F multiplizierten digitalen Daten als Ergebnis der Analog/Digital-Wandlung berücksichtigt. Dies ist in Fig. 2 dadurch angedeutet, daß das Ausgangssignal der Detektorschaltung 28 einen elektronischen Schalter 29 betätigt, der, wenn keine Überschreitung des Dynamikbereiches vorliegt, seine in Fig. 2 dargestellte Stellung einnimmt, in der dem Ausgang A das aufbereitete Signal AS zugeführt ist. Liegt dagegen eine Überschreitung des Dynamikbereiches vor, bringt das Ausgangssignal der Detektorschaltung 28 den elektronischen Umschalter 29 für die Dauer der Überschreitung in seine andere Stellung, so daß das Ausgang A das verstärkte Eingangssignal ES zugeführt ist.

Im Falle der beschriebenen ersten Betriebsart, die vor allem dann Anwendung finden kann, wenn hauptsächlich der dynamische Anteil des Eingangssignals ES und nicht dessen Gleichspannungsanteil interessiert, besteht also die Möglichkeit, solange keine Überschreitungen des Dynamikbereiches bezüglich des aufbereiteten Signals AS vorliegt, Spannungsänderungen des dynamischen Anteils des Eingangssignals ES zu messen, die um den definierten Verstärkungsfaktor V kleiner sind, als diejenige Spannungsänderung, die bei direkter Zufuhr des Eingangssignals ES zu dem Eingang des Analog/Digital-Wandlers 4 eine Änderung des Resultates der Analog/Digital-Wandlung um ein LSB bewirkt. Tritt eine Überschreitung des Dynamikbereiches bezüglich des aufbereiteten Signals AS auf oder interessieren die in dem Eingangssignal ES enthaltenen Gleichspannungsanteile, wird auf die aus der Analog/Digital-Wandlung des Eingangssignals ES gewonnenen und mit dem definierten Faktor F multiplizierten Daten zurückgegriffen. Die dabei auftretende Diskontinuität entspricht im wesentlichen nur dem in dem Eingangssignal ES enthaltenen Gleichspannungsanteil, da die dem Eingangssignal entsprechenden digitalen Daten mit dem definierten Faktor F multipliziert werden.

Für den Fall, daß auch die dem Eingangssignal ES entsprechenden digitalen Daten von Gleichspannungsanteilen befreit sein sollen, besteht die Möglichkeit, die beschriebene Betriebsart dahingehend zu modifizieren, daß die elektronische Recheneinrichtung 6 auf die dem Eingangssignal ES entsprechenden digitalen Daten vor oder nach der Multiplikation mit dem definierten Faktor F durch digitales Filtern eine zweite Übertragungsfunktion T2 anwendet, bei der es sich um die Übertragungsfunktion eines Hochpasses handelt, vorzugsweise die des bei der Bildung des aufbereiteten Signals AS verwendeten Hochpasses 10. Sieht man von der unterschiedlichen Auflösung ab, sind dann die Ergebnisse der Analog/Digital-Wandlung unabhängig davon, ob sie unter Heranziehung der dem aufbereiteten Signal AS entsprechenden digitalen Daten oder ohne Berücksichtigung der dem aufbereiteten Signal AS entsprechenden digitalen Daten unter Heranziehung der dem Eingangssignal ES entsprechenden digitalen Daten ermittelt wurden, direkt miteinander vergleichbar. Die modifizierte Betriebsart ist in Fig. 3, die ansonsten der Fig 2 entspricht, dadurch veranschaulicht, daß dem Verstärker 27 ein mittels des Schalters 30 überbrückbares Hochpaßfilter 31 mit dem Kondensator C und dem Widerstand R nachgeschaltet ist. Es versteht sich, daß es sich bei der den Übertragungsfunktionen T1 und T2 nicht notwendigerweise um die von Hochpässen handeln muß. Falls beispielsweise hochfrequente Signalanteile unterdrückt werden sollen, können die Übertragungsfunktionen auch die von Tiefpässen sein. Ebenso kann es sich bei den Übertragungsfunktionen um die von Kerbfiltern handeln. Es ist dann möglich, bestimmte Störfrequenzen auszufiltern.

In einer zweiten Betriebsart der erfindungsgemäßen Einrichtung wendet die elektronische Recheneinrichtung 6 auf die dem Eingangssignal ES entsprechenden, mit dem definierten Faktor F multiplizierten digitalen Daten durch digitales Filtern eine dritte Übertragungsfunktion T3 an. Bei der dritten Übertragungsfunktion T3 handelt es sich um das komplexe Komplement der ersten Übertragungsfunktion T1 , mit der das Eingangssignal ES zur Bildung des aufbereiteten Signals AS von Gleichspannungsanteilen befreit wird. Die durch das digitale Filtern erhaltenen digitalen Daten addiert die elektronische Recheneinrichtung 6 in zeitlich korrekter Beziehung zu den durch die Digital/Analog-Wandlung des aufbereiteten Signals AS erhaltenen digitalen Daten. Das Resultat dieser Addition berücksichtigt die elektronische Recheneinrichtung 6, solange bezüglich des aufbereiteten Signals AS keine Überschreitung des Dynamikbereiches vorliegt, als Ergebnis der Analog/Digital-Wandlung dar, während sie für den Fall, daß das aufbereitete Signal AS den Dynamikbereich überschreitet, wieder in der zuvor beschriebenen Weise die dem Eingangssignal ES entsprechenden, mit dem definierten Faktor F multiplizierten digitalen Daten, eventuell nach Anwendung der zweiten Übertragungsfunktion T2 durch digitales Filtern, als Ergebnis der Analog/Digital-Wandlung berücksichtigt.

Bekanntermaßen haben eine mathematische Funktion und das zu ihr gehörige komplexe Komplement die Eigenschaft, daß, wenn man sie jeweils mit einer dritten mathematischen Funktion multipliziert, die Summe der so erhaltenen Produkte der dritten mathematischen Funktion entspricht. Im vorliegenden Fall bedeutet dies, daß dem aufbereiteten Signal AS durch die beschriebene Addition diejenigen Signalanteile wieder hinzugefügt werden, die beim Durchlaufen des Hochpasses 10 verloren gehen. Dies hat zur Folge, daß in der zweiten Betriebsart auch dann, wenn das Ergebnis der Analog/Digital-Wandlung unter Heranziehung der dem aufbereiteten Signal AS entsprechenden digitalen Daten gewonnen wird, die in dem Eingangssignal ES enthaltenen Gleichspannungsanteile berücksichtigt sind. Da bei der digitalen Filterung eine "Interpolation" auch zwischen solchen dem Eingangssignal ES entsprechenden digitalen Daten stattfindet, die um ein LSB voneinander getrennt sind, wird der Vorteil erzielt, daß diejenigen digitalen Daten, die durch die beschriebene Addition zustande kommen, bei ausreichender Genauigkeit der im Zusammenhang mit der digitalen Filterung vorgenommenen Rechenvorgänge eine bit-Anzahl aufweisen, die größer als die bit-Anzahl des Analog/Digital-Wandlers 4 ist. Im Falle des beschriebenen Ausführungsbeispieles, wo der definierte Verstärkungsfaktor V und der definierte Faktor F jeweils 32 betragen, führt die elektronische Recheneinrichtung 6 die zur digitalen Filterung erforderlichen Rechenvorgänge mit einer solchen Genauigkeit aus, daß sich eine Erhöhung der bit-Anzahl z = 14 der Analog/Digital-Wandlung um 5 bit auf insgesamt 19 bit ergibt.

Im Falle des beschriebenen Ausführungsbeispieles durchläuft das Eingangssignal ES zur Bildung des aufbereiteten Signals AS einen Hochpaß erster Ordnung 10. Bei dem dessen Übertragungsfunktion T1 entsprechenden komplexen Komplement handelt es sich um die Übertragungsfunktion T3 eines Tiefpasses erster Ordnung, dessen Grenzfrequenz gleich der Grenzfrequenz des Hochpasses 10 ist. Es wird darauf hingewiesen, daß dies nicht in entsprechender Weise gilt, wenn anstelle des Hochpasses erster Ordnung 10 ein Hochpaß höherer Ordnung verwendet wird. In diesem Falle müssen der Übertragungsfunktion des entsprechenden Tiefpasses Korrekturglieder zugefügt werden, um das komplexe Komplement zu erhalten.

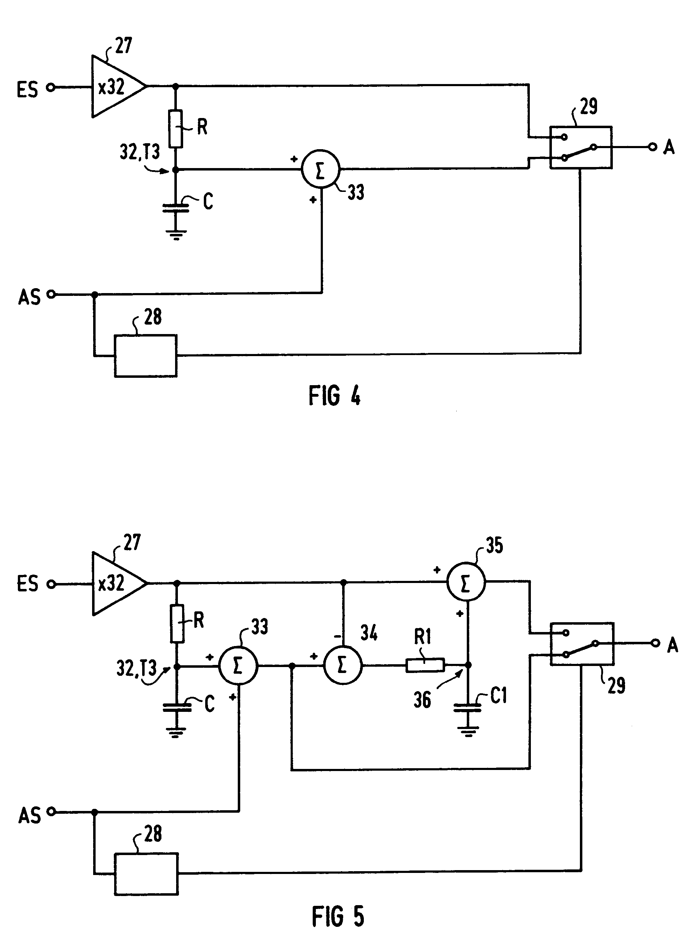

Im Falle der Fig. 4, die ansonsten der Fig. 2 entspricht, ist die zweite Betriebsweise dadurch verdeutlicht, daß mit dem Ausgang des Verstärkers 27 ein aus dem Widerstand R und dem Kondensator C gebildeter Tiefpaß erster Ordnung 32, die Werte des Widerstandes R und des Kondensators C entsprechen denen im Falle des Hochpasses 10, verbunden ist, dessen Ausgangssignal an dem Summationspunkt 33 rückwirkungsfrei zu dem aufbereiteten Signal AS addiert wird. Hinter dem Summationspunkt 33 steht also ein Signal zur Verfügung, das infolge des Umstandes, daß zu dem aufbereiteten Signal AS wieder diejenigen Signalanteile addiert werden, die zuvor mittels des Hochpasses 10 entfernt wurden, dem 32fach verstärkten Eingangssignal ES entspricht. Es wird somit deutlich, daß, solange bezüglich des aufbereiteten Signals AS keine Überschreitung des Dynamikbereiches vorliegt, die unter Heranziehung der dem aufbereiteten Signal AS entsprechenden digitalen Daten erhaltenen Ergebnisse der Analog/Digital-Wandlung eine vorzugsweise dem definierten Verstärkungsfaktor V entsprechende erhöhte Auflösung bieten und dennoch die im Eingangssignal ES enthaltenen Gleichspannungsanteile ebenfalls enthalten.

Wenn infolge von Überschreitungen des Dynamikbereiches bezüglich des aufbereiteten Signals AS auf die dem Eingangssignal ES entsprechenden digitalen Daten als Ergebnis der Digital/Analog-Wandlung übergegangen werden muß, können geringfügige Sprünge auftreten, die daraus resultieren, daß dem aufbereiteten Signal AS eine durch den Verstärker 11 verursachte Offset-Spannung überlagert ist. Diese Sprünge können in einer dritten Betriebsweise der erfindungsgemäßen Einrichtung vermieden werden. In dieser Betriebsweise ermittelt die elektronische Recheneinrichtung 6 für zusammengehörige Samples des Eingangssignals ES und des aufbereiteten Signals AS vorzeichenrichtig jeweils die Differenz zwischen den dem aufbereiteten Signal AS und den dem Eingangssignal ES entsprechenden, mit dem definierten Faktor F multiplizierten digitalen Daten. Außerdem bildet die elektronische Recheneinrichtung aus den für eine definierte Anzahl, z.B. 256, aufeinanderfolgender Samples ermittelten Differenzen unter Berücksichtigung von deren Vorzeichen den Mittelwert. Diesen addiert die elektronische Recheneinrichtung 6 zu den dem bei der Ermittlung des Mittelwertes jeweils zuletzt berücksichtigten Samples des Eingangssignals ES entsprechenden, mit dem definierten Faktor F multiplizierten digitalen Daten. Es wird also deutlich, daß die oben erwähnten, durch die Offset-Spannung des Verstärkers 11 verursachten Sprünge vermieden sind. Die beschriebene Mittelwertbildung ist nicht unbedingt erforderlich und kann daher auch entfallen. In Abhängigkeit davon, ob die erfindungsgemäße Einrichtung nach der in den Fig. 2 bzw. 3 oder nach der in der Fig. 4 verdeutlichten Betriebsart arbeitet, werden die Differenzen zwischen den dem Eingangssignal ES entsprechenden, mit dem definierten Faktor multiplizierten digitalen Daten oder den dem durch Anwendung der zweiten Übertragungsfunktion digital gefilterten Eingangssignal ES entsprechenden, mit dem definierten Faktor F multiplizierten digitalen Daten einerseits und den dem aufbereiteten Signal AS unmittelbar entsprechenden digitalen Daten oder den durch die beschriebene Addition nach der Anwendung der dritten Übertragungsfunktion gefilterten Eingangssignals ES erhaltenen digitalen Daten erhaltenen Summen andererseits gebildet. Grundsätzlich besteht auch die Möglichkeit, anders als zuvor beschrieben, den Mittelwert bzw., falls dieser nicht gebildet wird, die Differenzen in entsprechender Weise von den dem aufbereiteten Signal AS entsprechenden digitalen Daten zu subtrahieren.

In der Fig. 5, die ansonsten der Fig. 4 entspricht, ist die beschriebene Korrektur der Offset-Spannung des Verstärkers 11 dadurch veranschaulicht, daß an einem Summationspunkt 34 das verstärkte Eingangssignal ES von dem Ausgangssignal des Summierers 33 rückwirkungsfrei subtrahiert wird. Das der Offset-Spannung des Verstärkers 11 entsprechende Signal gelangt von dem Summationspunkte 34 zu einem integrierend wirkenden, aus einem Widerstand R1 und einem gegen Masse geschalteten Kondensator C1 gebildeten RC-Glied 36, mittels dessen eine Mittelwertbildung erfolgt. Der in dem Kondensator C1 gespeicherte Mittelwert wird an einem Summationspunkt 35 rückwirkungsfrei zu dem verstärkten Eingangssignal ES addiert. Wird infolge einer Überschreitung des Dynamikbereiches bezüglich des aufbereiteten Signals AS der elektronische Umschalter 29 von der Detektorschaltung 28 derart betätigt, daß das Signal von dem Summationspunkt 35 zu dem Ausgang A gelangt, tritt also kein Sprung auf. Die beiden Summationspunkte 34 und 35 sowie das RC-Glied 36 können in analoger, nicht dargestellter Weise auch im Falle der die zuerst beschriebenen Betriebsweisen veranschaulichenden Figuren 2 und 3 vorhanden sein.

In einer weiteren Betriebsart der erfindungsgemäßen Einrichtung wird von dem Signalgenerator 13 Gebrauch gemacht, der wie erwähnt ein Sägezahnsignal PS erzeugt. Bei dieser Betriebsart schließt die elektronische Recheneinrichtung durch ein entsprechendes Signal den elektronischen Schalter 14, so daß das Sägezahnsignal PS am Summationspunkt 16 dem Eingangssignal ES überlagert wird. Die Maximalamplitude des Sägezahnsignals PS ist wenigstens gleich demjenigen Spannungsunterschied, der eine Änderung der Ausgangsdaten des Analog/Digital-Wandlers 4 um ein LSB bewirkt. Die Periodendauer des Sägezahnsignals PS ist derart gewählt, daß während des Verlaufes des Sägezahnsignals PS entlang seiner linearen Flanke S von dem einen zu dem anderen Extremwert seiner Amplitude mittels des Analog/Digital-Wandlers 4 eine definierte Anzahl von Analog/Digital-Wandlungen vorgenommen wird. Die definierte Anzahl von Analog/Digital-Wandlungen ist vorzugsweise gleich dem definierten Verstärkungsfaktor V. Sie beträgt im Falle des beschriebenen Ausführungsbeispieles also 32.

Infolge des Umstandes, daß an dem Summationspunkt 16 eine Überlagerung des Eingangssignals ES mit dem Sägezahnsignal PS erfolgt, tritt am Ausgang der Sample and Hold-Schaltung 9 also ein treppenförmiges Signal auf, das über die Multiplexer 1 und 3 zu dem Analog/Digital-Wandler 4 gelangt. Abgesehen von dem Sonderfall, daß die maximale Amplitude des Sägezahnsignals PS gleich demjenigen Spannungsunterschied ist, der eine Änderung der Ausgangsdaten des Analog/Digital-Wandlers 4 um ein LSB bewirkt und außerdem die Mindest- oder Maximalamplitude des durch die Überlagerung des Eingangssignals ES mit dem Sägezahnsignal PS erhaltenen Signals exakt einem mittels des Analog/Digital-Wandlers 4 meßbaren Spannungswert entspricht, werden sich also die Ausgangsdaten des Analog/Digital-Wandlers 4 während des Verlaufes des Sägezahnsignals PS entlang seiner linearen Flanke S um wenigstens ein LSB ändern.

Auf die aus der Analog/Digital-Wandlung des Eingangssignals ES mit dem überlagerten Sägezahnsignal PS resultierenden Ausgangsdaten des Analog/Digital-Wandlers 4 wendet die elektronische Recheneinrichtung 6 eine vierte Übertragungsfunktion, die integrierend wirkt, in der Weise an, daß sie das Integral der Ausgangsdaten des Analog/Digital-Wandlers 4 für die bei der definierten Anzahl von Analog/Digital-Wandlungen zuletzt fortlaufend aufgetretenden Ausgangsdaten des Analog/Digital-Wandlers 4 bildet. Bei dieser Integration berücksichtigt die elektronische Recheneinrichtung 6 als Randbedingungen, die Maximalamplitude des Sägezahnsignals PS und die Lage des Sägezahnsignals PS relativ zu dem Eingangssignal ES nach der Überlagerung.

Als Resultat der Integration und damit als Resultat der Analog/Digital-Wandlung des Eingangssignals ES liefert die elektronische Recheneinrichtung 6 dann digitale Daten, deren bit-Anzahl größer als die bit-Anzahl des Analog/Digital-Wandlers ist. Dabei erhöht sich die bit-Anzahl entsprechend derjenigen Anzahl von Analog/Digital-Wandlungen, die während derjenigen Zeit vorgenommen werden, in der sich die Amplitude des Sägezahnsignals PS entlang seiner linearen Flanke um einen Wert ändert, der zu einer Änderung der Ausgangsdaten des Digital/Analog-Wandlers 4 um ein LSB führt. Ist wie im Falle des beschriebenen Ausführungsbeispieles die Maximalamplitude des Sägezahnsignals PS gleich einem LSB und werden während einer Periode des Sägezahnsignals PS 32 Analog/Digital-Wandlungen vorgenommen, erhöht sich also die bit-Anzahl der gemäß der zuletzt beschriebenen Betriebsart erhaltenen Ergebnisse der Analog/Digital-Wandlung von 14 auf 19 bit.

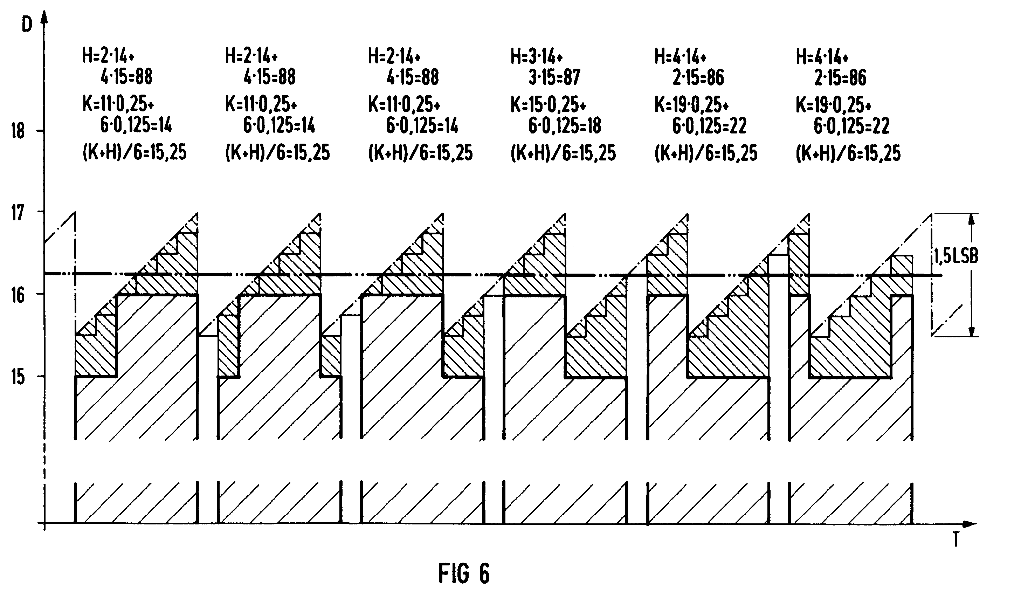

Die zuletzt beschriebene Betriebsweise der erfindungsgemäßen Einrichtung ist in Fig. 6 anhand eines Diagramms verdeutlicht, in dem einem konstanten Eingangssignal ES ein strichpunktiert eingetragenes Sägezahnsignal PS symmetrisch überlagert ist, dessen Amplitude 1,5 LSB beträgt. Während einer Periode des Sägezahnsignals PS werden sechs Analog/Digital-Wandlungen vorgenommen. Dies bedeutet, daß während derjenigen Zeit, in der sich die Amplitude des Sägezahnsignals PS um ein LSB ändert, vier Analog/Digital-Wandlungen vorgenommen werden. Wie dies anhand von sechs typischen Integrationsfeldern dargestellt ist, erfolgt die Integration jeweils über die Ausgangsdaten D von sechs aufeinanderfolgenden Analog/Digital-Wandlungen. Bei der Integration geht die elektronische Recheneinrichtung 6 derart vor, daß sie zunächst jeweils die Summe H von sechs aufeinanderfolgend angefallenen Ausgangsdaten des Digital/Analog-Wandlers 4 bildet. Die Summe F entspricht jeweils der in Fig. 6 von links nach rechts aufsteigend schraffierten Fläche. Außerdem ermittelt die elektronische Recheneinrichtung anhand der Anzahl K der höherwertigen Ausgangsdaten des Analog/Digital-Wandlers 4 jeweils die in Fig. 6 von links nach rechts abfallend schraffierten Flächen. Dies geschieht anhand eines den jeweiligen Gegebenheiten angepaßten, für den Fachmann leicht auffindbaren Algorithmus. Für jeden Integrationsvorgang addiert die elektronische Recheneinrichtung die Werte H und K und dividiert diese durch die Anzahl der während der Periodendauer vorgenommenen Analog/Digital-Wandlungen. Das Ergebnis der Division entspricht dem Resultat der Analog/Digital-Wandlung gemäß der zuletzt beschriebenen Betriebsweise und beträgt im Falle der Fig. 6 16,25.

Es ist leicht einzusehen, daß anstelle des im Falle des beschriebenen Ausführungsbeispieles verwendeten Sägezahnsignals PS auch ein beliebiges anderes Signal mit einer statistisch gleichmäßigen Amplitudenverteilung, z.B. ein Rauschsignal, dem Eingangssignal ES überlagert werden kann, um die beschriebene Erhöhung der bit-Anzahl der Analog/Digital-Wandlung zu erreichen.

In einer letzten Betriebsart, die zur Eichung bzw. zum Abgleich der erfindungsgemäßen Einrichtung dient, wird, indem die elektronische Recheneinrichtung den elektronischen Schalter 15 schließt (der elektronische Schalter 14 ist geöffnet), das Sägezahnsignal PS dem Summationspunkt 17 zugeführt. Das Sägezahnsignal PS wird also sowohl dem Eingangssignal ES als auch dem aufbereiteten Signal AS überlagert. Bezüglich des Eingangssignals ES erfolgt die Analog/Digital-Wandlung in der im Zusammemhang mit Fig. 6 zuvor beschriebenen Weise mit erhöhter bit-Anzahl, während sie gleichzeitig bezüglich des aufbereiteten Signals AS unter Anwendung der dritten Übertragungsfunktion gemäß Fig. 4 erfolgt. Außerdem nimmt die elektronische Recheneinrichtung 6 bezüglich der Offset-Spannung des Verstärkers 11 die im Zusammenhang mit Fig. 5 beschriebene Korrektur vor. Der Einrichtung wird nun ein beliebiges Signal zugeführt, das allerdings bezüglich des aufbereiteten Signals AS nicht zu Überschreitungen des Dynamikbereiches führen darf. Es besteht auch die Möglichkeit, den Eingang der Einrichtung kurzzuschließen, was bedeutet, daß das Eingangssignal ES den Wert Null besitzt. Die elektronische Recheneinrichtung vergleicht dann die unter Heranziehung der dem aufbereiteten Signal AS entsprechenden digitalen Daten ermittelten Ergebnisse der Analog/Digital-Wandlung mit den ohne Berücksichtigung der dem aufbereiteten Signal AS entsprechenden digitalen Daten unter Heranziehung der dem Eingangssignal ES entsprechenden, mit dem definierten Faktor F multiplizierten digitalen Daten ermittelten Ergebnisse der Analog/Digital-Wandlung in der Weise, daß sie deren Differenzen bildet. Im Idealfall geben die Differenzen den Verlauf des Sägezahnsignals PS wieder, da dieses im Falle der Ermittlung der Ergebnisse der Analog/Digital-Wandlung unter Heranziehung der dem aufbereiteten signal AS entsprechenden digitalen Daten als Signalanteil aufgefaßt wird, im Falle der Analog/Digital-Wandlung des Eingangssignals ES jedoch nur als Hilfssignal verwendet wird. Falls die mittels der elektronischen Recheneinrichtung 6 gebildeten Differenzen wesentlich von dem Sägezahnsignal PS abweichen, kann ein Abgleich der erfindungsgemäßen Einrichtung er folgen. Dies kann beispielsweise durch Anpassung der dritten Übertragungsfunktion T3 an die Bauteilwerte des Hochpasses 10, durch Korrektur des definierten Verstärkungsfaktors V, falls dieser einstellbar ist, oder durch Korrektur des definierten Faktors F geschehen.

## Patentansprüche

1. Verfahren zur Analog/Digital-Wandlung eines sich zeitlich ändernden analogen elektrischen Eingangssignals (ES) mit folgenden Verfahrensschritten:
a) Zur Bildung eines aufbereiteten Signals (AS) wird auf das Eingangssignal (ES) eine erste nicht reelle Übertragungsfunktion (T1) angewendet und das Eingangssignal (ES) um einen definierten Verstärkungsfaktor (V) verstärkt,
b) zeitich aufeinanderfolgende Samples sowohl des Eingangssignals (ES) als auch des aufbereiteten Signals (AS) werden jeweils einer Analog/Digital-Wandlung unterzogen, so daß dem Eingangssignal (ES) entsprechende digitale Daten einer bestimmten bit-Anzahl und dem aufbereiteten Signal (AS) entsprechende digitale Daten einer bestimmten bit-Anzahl erhalten werden, wobei die bit-Anzahl jeweils den Dynamikbereich der Analog/Digital-Wandlung bestimmt,
c) die dem Eingangssignal (ES) entsprechenden digitalen Daten werden jeweils mit einem definierten Faktor (F) multipliziert, der gleich dem definierten Verstärkungsfaktor (V) ist,
d) bezüglich der dem aufbereiteten Signal (AS) entsprechenden Daten wird geprüft, ob eine Überschreitung des zugehörigen Dynamikbereiches vorliegt, und
e) die Ergebnisse der Analog/Digital-Wandlung werden unter Heranziehung der dem aufbereiteten Signal (AS) entsprechenden digitalen Daten ermittelt, solange das aufbereitete Signal (AS) innerhalb des Dynamikbereiches liegt, und ohne Berücksichtigung der dem aufbereiteten Signal (AS) entsprechenden digitalen Daten unter Heranziehung der dem Eingangssignal (ES) entsprechenden, mit dem definierten Faktor (F) multiplizierten digitalen Daten, solange bezüglich des aufbereiteten Signals (AS) eine Überschreitung des Dynamikbereiches vorliegt.

2. Verfahren nach Anspruch 1, **dadurch gekennzeichnet,**daß als erste Übertragungsfunktion (T1) die Übertragungsfunktion eines Hochpasses angewendet wird.

3. Verfahren nach Anspruch 1 oder 2, **dadurch gekennzeichnet,** daß auf die dem Eingangssignal (ES) entsprechenden digitalen Daten vor ihrer Heranziehung zur Ermittlung der Ergebnisse der Analog/Digital-Wandlung durch digitales Filtern eine zweite Übertragungsfunktion (T2) angewendet wird.

4. Verfahren nach Anspruch 3, **dadurch gekennzeichnet,** daß als zweite Übertragungsfunktion (T2) die Übertragungsfunktion eines Hochpasses angewendet wird.

5. Verfahren nach einem der Ansprüche 1 bis 4, **dadurch gekennzeichnet,** daß, solange das aufbereitete Signal (AS) innerhalb des Dynamikbereiches liegt, die Ergebnisse der Analog/Digital-Wandlung zusätzlich unter Heranziehung der dem Eingangssignal (ES) entsprechenden, mit dem definierten Faktor (F) multiplizierten digitalen Daten ermittelt werden und daß auf diese zuvor durch digitales Filtern eine dritte Übertragungsfunktion (T3) angewendet wird.

6. Verfahren nach Anspruch 5, **dadurch gekennzeichnet,** daß die dritte Übertragungsfunktion (T3) das komplexe Komplement der ersten Übertragungsfunktion (T1) ist und daß die dem Eingangssignal (ES) entsprechenden digitalen Daten zur Ermittlung der Ergebnisse der Analog/Digital-Wandlung in der Weise herangezogen werden, daß die Summen der durch digitales Filtern des Eingangssignals (ES) erhaltenen digitalen Daten und der dem aufbereiteten Signal (AS) entsprechenden digitalen Daten gebildet werden.

7. Verfahren nach einem der Ansprüche 1 bis 6, **dadurch gekennzeichnet,** daß für zeitlich aufeinanderfolgende Samples die Differenz zwischen den dem Eingangssignal (ES) entsprechenden, mit dem definierten Faktor (F) multiplizierten digitalen Daten und den dem aufbereiteten Signal (AS) entsprechenden digitalen Daten gebildet wird und daß die so erhaltenen Differenzen zur Korrektur von Offset-Fehlern verwendet werden.

8. Verfahren nach Anspruch 7, **dadurch gekennzeichnet,** daß aus den für eine definierte Anzahl aufeinanderfolgender Sample 5 ermittelten Differenzen unter Berücksichtigung von deren Vorzeichen der Mittelwert gebildet wird und daß der Mittelwert zur Korrektur von Offset-Fehlern verwendet wird.

9. Verfahren nach einem der Ansprüche 1 bis 8, **dadurch gekennzeichnet,** daß dem Eingangssignal (ES) vor der Analog/Digital-Wandlung ein sich zeitlich änderndes analoges elektrisches Signal (PS) überlagert wird, dessen Maximalamplitude wenigstens gleich demjenigen Spannungsunterschied ist, der einem least-significant-bit (LSB) bei der Analog/Digital-Wandlung des Eingangssignals (ES) entspricht, und das eine statistisch gleichmäßige Amplitudenverteilung aufweist, daß nach der Analog/Digital-Wandlung auf die dem aus der Überlagerung des Eingangssignals (ES) und des analogen Signals (PS) resultierenden Signal entsprechenden digitalen Daten durch digitales Filtern eine vierte Übertragungsfunktion angewendet wird, welche integrierend wirkt, und daß die so erhaltenen digitalen Daten als dem Eingangssignal (ES) entsprechenden digitalen Daten verwendet werden.

10. Verfahren nach Anspruch 9, **dadurch gekennzeichnet,** daß als vierte Übertragungsfunktion die Übertragungsfunktion eines Tiefpasses angewendet wird.

11. Verfahren nach Anspruch 9 oder 10, **dadurch gekennzeichnet,** daß das analoge Signal (PS) ein periodisches Signal ist.

12. Einrichtung zur Analog/Digital-Wandlung eines sich zeitlich ändernden analogen elektrischen Eingangssignales (ES), umfassend Mittel (10, 11) zur Bildung eines aufbereiteten Signales (AS), welche auf das Eingangssignal (ES) eine erste nicht reelle Übertragungsfunktion (T1) anwenden und das Eingangssignal (ES) um einen definierten Verstärkungsfaktor (V) verstärken, Mittel (4, 9, 12) zur Analog/Digital-Wandlung, welche aufeinanderfolgende Samples sowohl des Eingangssignales (ES) als auch des aufbereiteten Signales (AS) jeweils einer Analog/Digital-Wandlung unterziehen, so daß dem Eingangssignal (ES) entsprechende digitale Daten einer bestimmten bit-Anzahl und dem aufbereiteten Signal (AS) entsprechende digitale Daten einer bestimmten bit-Anzahl als Ausgangsdaten der Mittel zur Analog/Digital-Wandlung vorliegen, wobei die bit-Anzahl jeweils den Dynamikbereich der Mittel zur Analog/Digital-Wandlung bestimmt, und eine mit den Mitteln (4, 9, 12) zur Analog/Digital-Wandlung zusammenwirkende elektronische Recheneinrichtung (6), welcher die Ausgangsdaten der Mittel (4, 9, 12) zur Analog/Digital-Wandlung zugeführt sind, wobei die elektronische Recheneinrichtung (6) derart ausgebildet ist,
a) daß sie die dem Eingangssignal (ES) entsprechenden digitalen Daten jeweils mit einem definierten Faktor (F) multipliziert, der gleich dem definierten Verstärkungsfaktor (V) ist,
b) daß sie bezüglich der dem aufbereiteten Signal (AS) entsprechenden Daten überprüft, ob eine Überschreitung des zugehörigen Dynamikbereiches vorliegt, und
c) daß sie die Ergebnisse der Analog/Digital-Wandlung unter Heranziehung der dem aufbereiteten Signal (AS) entsprechenden digitalen Daten ermittelt, solange das aufbereitete Signal (AS) innerhalb des Dynamikbereiches liegt, und ohne Berücksichtigung der dem aufbereiteten Signal (AS) entsprechenden digitalen Daten unter Heranziehung der dem Eingangssignal (ES) entsprechenden, mit dem definierten Faktor (F) multiplizierten Daten, solange bezüglich des aufbereiteten Signales (AS) eine Überschreitung des Dynamikbereiches vorliegt.

13. Einrichtung nach Anspruch 12, **dadurch gekennzeichnet,** daß die Mittel (10, 11) zur Bildung des aufbereiteten Signales (AS) als erste Übertragungsfunktion (T1) die Übertragungsfunktion eines Hochpasses auf das Eingangssignal (ES) anwenden.

14. Einrichtung nach Anspruch 12 oder 13, **dadurch gekennzeichnet,** daß die elektronische Recheneinrichtung (6) derart ausgebildet ist, daß sie auf die dem Eingangssignal (ES) entsprechenden digitalen Daten vor ihrer Heranziehung zur Ermittlung der Ergebnisse der Analog/Digital-Wandlung durch digitales Filtern eine zweite Übertragungsfunktion (T2) anwendet.

15. Einrichtung nach Anspruch 14, **dadurch gekennzeichnet,** daß die elektronische Recheneinrichtung (6) derart ausgebildet ist, daß sie auf die dem Eingangssignal (ES) entsprechenden digitalen Daten die Übertragungsfunktion eines Hochpasses anwendet.

16. Einrichtung nach einem der Ansprüche 12 bis 15, **dadurch gekennzeichnet,** daß die elektronische Recheneinrichtung (6) derart ausgebildet ist, daß sie, solange das aufbereitete Signal (AS) innerhalb des Dynamikbereiches liegt, die Ergebnisse der Analog/Digital-Wandlung zusätzlich unter Heranziehung der dem Eingangssignal (ES) entsprechenden, mit dem definierten Faktor (F) multiplizierten digitalen Daten ermittelt und auf diese zuvor durch digitales Filtern eine dritte Übertragungsfunktion (T3) anwendet.

17. Einrichtung nach Anspruch 16, **dadurch gekennzeichnet,** daß die elektronische Recheneinrichtung (6) derart ausgebildet ist, daß sie auf die dem Eingangssignal (ES) entsprechenden, mit dem definierten Faktor (F) multiplizierten digitalen Daten als dritte Übertragungsfunktion (T3) das komplexe Komplement der ersten Übertragungsfunktion (T1) anwendet und daß sie die dem Eingangssignal (ES) entsprechenden digitalen Daten zur Ermittlung der Ergebnisse der Analog/Digital-Wandlung in der Weise heranzieht, daß sie die Summen der durch digitales Filtern des Eingangssignales (ES) erhaltenen digitalen Daten und der dem aufbereiteten Signal (AS) entsprechenden digitalen Daten bildet.

18. Einrichtung nach einem der Ansprüche 12 bis 17, **dadurch gekennzeichnet,** daß die elektronische Recheneinrichtung (6) derart ausgebildet ist, daß sie für zeitlich aufeinanderfolgende Samples die Differenz zwischen den dem Eingangssignal (ES) entsprechenden, mit dem definierten Faktor (F) multiplizierten digitalen Daten und den dem aufbereiteten Signal (AS) entsprechenden digitalen Daten bildet und die so erhaltenen Differenzen zur Korrektur von Offset-Fehlern verwendet.

19. Einrichtung nach Anspruch 18, **dadurch gekennzeichnet,** daß die elektronische Recheneinrichtung (6) derart ausgebildet ist, daß sie aus den für eine definierte Anzahl aufeinanderfolgender Samples ermittelten Differenzen unter Berücksichtigung von deren Vorzeichen den Mittelwert bildet und diesen zur Korrektur von Offset-Fehlern verwendet.

20. Einrichtung nach einem der Ansprüche 12 bis 19, **dadurch gekennzeichnet,** daß Mittel (13) zur Erzeugung eines analogen Signales (PS) vorgesehen sind, die ein analoges Signal (PS) erzeugen, dessen Maximalamplitude wenigstens gleich demjenigen Spannungsunterschied ist, der einem least significant bit (LSB) bei der Analog/Digital-Wandlung des Eingangssignales (ES) entspricht, und das eine statistisch gleichmäßige Amplitudenverteilung aufweist, daß Mittel (14, 15, 16, 17) zur Überlagerung des periodischen Signales (PS) mit dem Eingangssignal (ES) vorgesehen sind, und daß die elektronische Recheneinrichtung (6) derart ausgebildet ist, daß sie auf die dem aus der Überlagerung des Eingangssignales (ES) und des analogen Signales (PS) resultierenden Signal entsprechenden Ausgangsdaten der Mittel (4, 9, 12) zur Analog-Digital-Wandlung durch digitales Filtern eine vierte Übertragungsfunktion anwendet, welche integrierend wirkt, und daß sie die so erhaltenen digitalen Daten als dem Eingangssignal (ES) entsprechende digitale Daten verwendet.

21. Einrichtung nach Anspruch 20, **dadurch gekennzeichnet,** daß die elektronische Recheneinrichtung (6) derart ausgebildet ist, daß sie als vierte Übertragungsfunktion auf die dem resultierenden Signal entsprechenden digitalen Daten die Übertragungsfunktion eines Tiefpasses anwendet.

22. Einrichtung nach Anspruch 20 oder 21, **dadurch gekennzeichnet,** daß die Mittel (13) zur Erzeugung eines analogen Signales (PS) ein periodisches Signal erzeugen.

23. Einrichtung nach einem der Ansprüche 12 bis 22, **dadurch gekennzeichnet,** daß zur Eichung
a) dem Eingangssignal (ES) vor der Bildung des aufbereiteten Signales (AS) ein analoges Wechselspannungssignal (PS) überlagert wird, und
b) solange das aufbereitete Signal (AS) innerhalb des Dynamikbereiches liegt, für die einzelnen Samples ein Vergleich der unter Heranziehung der dem aufbereiteteten Signal (AS) entsprechenden digitalen Daten ermittelten Ergebnissen der Analog/Digital-Wandlung mit den ohne Berücksichtigung der dem aufbereiteten Signal (AS) entsprechenden digitalen Daten unter Heranziehung der dem Eingangssignal (ES) entsprechenden, mit dem definierten Faktor (F) multiplizierten digitalen Daten ermittelten Ergebnissen der Analog/Digital-Wandlung vorgenommen wird.

24. Einrichtung nach Anspruch 23, **dadurch gekennzeichnet,** daß die Ergebnisse des Vergleiches zur Fehlerkorrektur verwendet werden.

25. Einrichtung nach Anspruch 23 oder 24 zur Eichung einer Einrichtung nach einem der Ansprüche 20 bis 22, **dadurch gekennzeichnet,** daß das mittels der Mittel (13) zur Erzeugung eines analogen Signales (PS) erzeugte Signal dem Eingangssignal (ES) überlagert wird.

26. Einrichtung nach einem der Ansprüche 23 bis 25, **dadurch gekennzeichnet,** daß während des Eichvorganges das Eingangssignal (ES) den Wert Null besitzt.

## Claims

1. Method for the analogue-to-digital conversion of a chronologically changing analogue electrical input signal (ES), having the following method steps:
a) for forming a processed signal (AS), a first non-real transfer function (T1) is applied to the input signal (ES) and the input signal (ES) is amplified by a defined gain factor (V),
b) respective chronologically successive samples of both the input signal (ES) and the processed signal (AS) are subjected to an analogue-to-digital conversion so as to obtain digital data corresponding to the input signal (ES) and having a pre-determined number of bits, and digital data corresponding to the processed signal (AS) and having a pre-determined number of bits, wherein the respective number of bits defines the dynamic range of the analogue-to-digital conversion,
c) the digital data corresponding to the input signal (ES) are multiplied, respectively, by a defined factor (F) which is equal to the defined gain factor (V),
d) checks are made with regard to the data corresponding to the processed signal (AS) to detect whether the dynamic range associated with it is exceeded, and
e) the results of the analogue-to-digital conversion are calculated on the basis of the digital data corresponding to the processed signal (AS), as long as the processed signal (AS) is within the dynamic range, and on the basis of the digital data corresponding to the input signal (ES) and multiplied by the defined factor (F), without taking into consideration the digital data corresponding to the processed signal (AS), if the dynamic range is exceeded with regard to the processed signal (AS).

2. Method according to claim 1, characterised in that the transfer function of a high-pass filter is used as the first transfer function (T1).

3. Method according to claim 1 or 2, characterised in that a second transfer function (T2) is applied to the digital data corresponding to the input signal (ES), by means of digital filtering, before the results of the analogue-to-digital conversion are calculated on the basis of the said digital data.

4. Method according to claim 3, characterised in that the transfer function of a high-pass filter is used as the second transfer function (T2).

5. Method according to one of claims 1 to 4, characterised in that, as long as the processed signal (AS) is within the dynamic range, the results of the analogue-to-digital conversion are additionally calculated on the basis of the digital data corresponding to the input signal (ES) and multiplied by the defined factor (F), and in that a third transfer function (T3) is applied to the said digital data beforehand by means of digital filtering.

6. Method according to claim 5, characterised in that the third transfer function (T3) is the complex complement of the first transfer function (T1), and in that the results of the analogue-to-digital conversion are calculated on the basis of the digital data corresponding to the input signal (ES), in such a way that the sums of the digital data obtained by digital filtering of the input signal (ES) and the digital data corresponding to the processed signal (AS), are formed.

7. Method according to one of claims 1 to 6, characterised in that, for chronologically successive samples, there is formed the difference between the digital data corresponding to the input signal (ES) and multiplied by the defined factor (F), and the digital data corresponding to the processed signal (AS), and in that the differences obtained in this way are used to correct offset errors.

8. Method according to claim 7, characterised in that the average of the differences determined for a defined number of successive samples is formed, taking the operational signs of the said differences into consideration, and in that the average is used to correct offset errors.

9. Method according to one of claims 1 to 8, characterised in that a chronologically changing analogue electrical signal (PS) having a maximum amplitude which is at least equal to the voltage difference corresponding to a least significant bit (LSB) during the analogue-to-digital conversion of the input signal (ES), and having a statistically uniform amplitude distribution, is superimposed on the input signal (ES) before the analogue-to-digital conversion, in that after the analogue-to-digital conversion a fourth transfer function is applied by means of digital filtering to the digital data corresponding to the signal resulting from the superimposition of the input signal (ES) and the analogue signal (PS), this fourth transfer function having an integrating effect, and in that the digital data obtained in this way are used as digital data corresponding to the input signal (ES).

10. Method according to claim 9, characterised in that the transfer function of a low-pass filter is used as the fourth transfer function.

11. Method according to claim 9 or 10, characterised in that the analogue signal (PS) is a periodic signal.

12. Device for the analogue-to-digital conversion of a chronologically changing analogue electrical input signal (ES), comprising means (10, 11) for forming a processed signal (AS) which apply a first non-real transfer function (T1) to the input signal (ES) and amplify the input signal (ES) by a defined gain factor (V), means (4, 9, 12) for analogue-to-digital conversion which subject respective successive samples of both the input signal (ES) and the processed signal (AS) to an analogue-to-digital conversion, so that digital data corresponding to the input signal (ES) and having a pre-determined number of bits, and digital data corresponding to the processed signal (AS) and having a pre-determined number of bits are present as the output data of the means for analogue-to-digital conversion, wherein the respective number of bits defines the dynamic range of the means for analogue-to-digital conversion, and an electronic computing device (6) cooperating with the means (4, 9, 12) for analogue-to-digital conversion, the output data of the means (4, 9, 12) for analogue-to-digital conversion being supplied to the said electronic computing device, wherein the electronic computing device (6) is constructed so that
a) it multiplies the digital data corresponding to the input signal (ES) by a respective defined factor (F) which is equal to the defined gain factor (V),
b) it makes checks with regard to the data corresponding to the processed signal (AS) to detect whether the dynamic range associated with it is exceeded, and
c) it calculates the results of the analogue-to-digital conversion on the basis of the digital data corresponding to the processed signal (AS), as long as the processed signal (AS) is within the dynamic range, and on the basis of the data corresponding to the input signal (ES) and multiplied by the defined factor (F), without taking into consideration the digital data corresponding to the processed signal (AS), if the dynamic range is exceeded with regard to the processed signal (AS).

13. Device according to claim 12, characterised in that the means (10, 11) for forming the processed signal (AS) apply the transfer function of a high-pass filter to the input signal (ES), as the first transfer function (T1).

14. Device according to claim 12 or 13, characterised in that the electronic computing device (6) is constructed so that it applies a second transfer function (T2) by means of digital filtering to the digital data corresponding to the input signal (ES), before calculating the results of the analogue-to-digital conversion on the basis of the said digital data.

15. Device according to claim 14, characterised in that the electronic computing device (6) is constructed so that it applies the transfer function of a high-pass filter to the digital data corresponding to the input signal (ES).

16. Device according to one of claims 12 to 15, characterised in that the electronic computing device (6) is constructed so that, as long as the processed signal (AS) is within the dynamic range, the electronic computing device (6) additionally calculates the results of the analogue-to-digital conversion on the basis of the digital data corresponding the input signal (ES) and multiplied by the defined factor (F), and applies a third transfer function (T3) to the said digital data beforehand by means of digital filtering.

17. Device according to claim 16, characterised in that the electronic computing device (6) is constructed so that it applies the complex complement of the first transfer function (T1) as the third transfer function (T3) to the digital data corresponding to the input signal (ES) and multiplied by the defined factor (F), and in that it calculates the results of the analogue-to-digital conversion on the basis of the digital data corresponding to the input signal (ES), in such a way that it sums the digital data obtained by means of digital filtering of the input signal (ES) and the digital data corresponding to the processed signal (AS).

18. Device according to one of claims 12 to 17, characterised in that the electronic computing device (6) is constructed so that, for chronologically successive samples, it forms the difference between the digital data corresponding to the input signal (ES) and multiplied by the defined factor (F), and the digital data corresponding to the processed signal (AS), and uses the differences obtained in this way for correcting offset errors.

19. Device according to claim 18, characterised in that the electronic computing device (6) is constructed so that it forms an average of the differences calculated for a defined number of successive samples, taking the operational signs of the differences into consideration, and uses this average for correcting offset errors.

20. Device according to one of claims 12 to 19, characterised in that means (13) are provided for generating an analogue signal (PS), which means generate an analogue signal (PS) having a maximum amplitude which is at least equal to the voltage difference corresponding to a least significant bit (LSB) during the analogue-to-digital conversion of the input signal (ES), and having a statistically uniform amplitude distribution, in that means (14, 15, 16, 17) are provided for superimposing the periodic signal (PS) with the input signal (ES), and in that the electronic computing device (6) is constructed so that it applies a fourth transfer function by means of digital filtering to the output data of the means (4, 9, 12) for analogue-to-digital conversion, which output data correspond to the signal resulting from the superimposition of the input signal (ES) and the analogue signal (PS), this fourth transfer function having an integrating effect, and in that the digital data obtained in this way are used as digital data corresponding to the input signal (ES).

21. Device according to claim 20, characterised in that the electronic computing device (6) is constructed so that it applies the transfer function of a low-pass filter as the fourth transfer function to the digital data corresponding to the resulting signal.

22. Device according to claim 20 or 21, characterised in that the means (13) for generating an analogue signal (PS) generate a periodic signal.

23. Device according to one of claims 12 to 22, characterised in that, for calibration,
a) an analogue a.c. voltage signal (PS) is superimposed on the input signal (ES) before the processed signal (AS) is formed, and
b) as long as the processed signal (AS) is within the dynamic range, for the individual samples there is undertaken a comparison of the results of the analogue-to-digital conversion calculated on the basis of the digital data corresponding to the processed signal (AS) with the results of the analogue-to-digital conversion calculated on the basis of the digital data corresponding to the input signal (ES) and multiplied by the defined factor (F), without taking into consideration the digital data corresponding to the processed signal (AS).

24. Device according to claim 23, characterised in that the results of the comparison are used for correction of errors.

25. Device according to claim 23 or 24 for calibration of a device according to one of claims 20 to 22, characterised in that the signal generated by means of the means (13) for generating an analogue signal (PS) is superimposed on the input signal (ES).

26. Device according to one of claims 23 to 25, characterised in that the value of the input signal (ES) is zero during the calibration operation.

## Revendications

1. Procédé pour réaliser la conversion analogique/numérique d'un signal d'entrée électrique analogique (ES), qui varie dans le temps, présentant les étapes opératoires suivantes :
a) pour former un signal préparé (AS), on applique au signal d'entrée (ES) une première fonction de transfert non réelle (T1) et on amplifie le signal d'entrée (ES) d'un facteur d'amplification défini (B),
b) on soumet des échantillons successifs dans le temps aussi bien du signal d'entrée (ES) que du signal préparé (AS), respectivement à une conversion analogique/numérique de sorte que l'on obtient des données numériques, qui correspondent au signal d'entrée (ES) et possèdent un nombre de bits déterminés, et des données numériques, qui correspondent au signal préparé (AS) et qui possèdent un nombre de bits déterminé, le nombre de bits déterminant respectivement la gamme dynamique de la conversion analogique/numérique,
c) on multiplie les données numériques, qui correspondent au signal d'entrée (ES), respectivement par un facteur défini (F), qui est égal au facteur d'amplification défini (V),
d) en rapport avec les données qui correspondent au signal préparé (AS), on vérifie si on est en présence d'un dépassement de la gamme dynamique associée, et
e) on détermine les résultats de la conversion analogique/numérique en utilisant les données numériques, qui correspondent au signal préparé (AS), tant que ce signal préparé (AS) est situé dans la gamme dynamique, et sans tenir compte des données numériques, qui correspondent au signal préparé (AS), moyennant l'utilisation des données numériques, qui correspondent au signal d'entrée (ES) et sont multipliées par le facteur défini (F), tant qu'il existe un dépassement de la gamme dynamique en rapport avec le signal préparé (AS).

2. Procédé suivant la revendication 1, caractérisé par le fait qu'on utilise comme première fonction de transfert (T1), la fonction de transfert d'un filtre passe-haut.

3. Procédé suivant la revendication 1 ou 2, caractérisé par le fait qu'on applique une seconde fonction de transfert (T2) aux données numériques, qui correspondent au signal d'entrée (ES), avant son utilisation pour déterminer les résultats de la conversion analogique/numérique, au moyen d'un filtrage numérique.

4. Procédé suivant la revendication 3, caractérisé par le fait qu'on utilise, comme seconde fonction de transfert (T2), la fonction de transfert d'un filtre passe-haut.

5. Procédé suivant l'une des revendications 1 à 4, caractérisé par le fait que, dans le cas où le signal préparé (AS) est situé à l'intérieur de la gamme dynamique, les résultats de la conversion analogique/numérique sont déterminés en outre en utilisant les données numériques qui correspondent au signal d'entrée (ES) et sont multipliées par le facteur défini (F), et qu'on applique au préalable à ces données une troisième fonction de transfert moyennant un filtrage numérique.

6. Procédé suivant la revendication 5, caractérisé par le fait que la troisième fonction de transfert (T3) est le complément complexe de la première fonction de transfert (T1) et que les données numériques correspondant au signal d'entrée (ES) sont utilisées pour déterminer les résultats de la conversion analogique/numérique de manière à former les sommes des données numériques obtenues par filtrage numérique du signal d'entrée (ES) et des données numériques correspondant au signal préparé (AS).

7. Procédé suivant l'une des revendications 1 à 6, caractérisé par le fait que pour des échantillons successifs dans le temps, on forme la différence entre les données numériques qui correspondent au signal d'entrée (ES) et qui sont multipliées par le facteur défini (F), et les données numériques, qui correspondent au signal préparé (AS), et qu'on utilise les différences ainsi obtenues pour corriger des erreurs d'offset.

8. Procédé suivant la revendication 7, caractérisé par le fait qu'on forme la valeur moyenne à partir des différences déterminées pour un nombre défini d'échantillons successifs, en tenant compte de leurs signes et qu'on utilise la valeur moyenne pour corriger des erreurs d'offset.

9. Procédé suivant l'une des revendications 1 à 8, caractérisé par le fait qu'on superpose au signal d'entrée (ES), avant la conversion analogique/numérique, un signal électrique analogique (PS), qui varie dans le temps et dont l'amplitude maximale est au moins égale à la différence de tension qui correspond à un bit de poids le plus faible (LSB) lors de la conversion analogique/numérique du signal d'entrée (ES), et qui possède une distribution d'amplitudes statistiquement uniforme, qu'après la conversion analogique/numérique, on applique aux données numériques qui correspondent au signal qui résulte de la superposition du signal d'entrée (ES) et du signal analogique (PS), par filtrage numérique, une quatrième fonction de transfert, qui agit avec un effet d'intégration, et que les données numériques ainsi obtenues sont utilisées en tant que données numériques qui correspondent au signal d'entrée (ES).

10. Procédé suivant la revendication 9, caractérisé par le fait qu'on utilise, comme quatrième fonction de transfert, la fonction de transfert d'un filtre passe-bas.

11. Procédé suivant la revendication 9 ou 10, caractérisé par le fait que le signal analogique (PS) est un signal périodique.

12. Dispositif de conversion analogique/numérique d'un signal d'entrée électrique analogue (ES) variable dans le temps, comprenant des moyens (10, 11) pour former un signal préparé (AS) et qui appliquent au signal d'entrée (ES) une première fonction de transfert non réelle (T1) et amplifient le signal d'entrée (ES) d'un facteur d'amplification défini (V), des moyens (4, 9, 12) servant à réaliser la conversion analogique/numérique et qui soumettent des échantillons successifs aussi bien du signal d'entrée (ES) que du signal préparé (AS) respectivement à une conversion analogique/numérique, de sorte que des données numériques correspondant au signal d'entrée (ES) et possédant un nombre déterminé de bits, et des données numériques, correspondant au signal préparé (AS) et possédant un nombre déterminé de bits sont présentes en tant que données de sortie des moyens de conversion analogique/numérique, auquel cas le nombre de bits détermine respectivement la gamme dynamique des moyens de conversion analogique/numérique, et un dispositif de calcul électronique (6), qui coopère avec les moyens (4, 9, 12) de conversion analogique/numérique et auxquels sont envoyées les données de sortie des moyens (4, 9, 12) de conversion analogique/numérique, le dispositif de calcul électronique (6) étant agencé de telle sorte que
a) il multiplie les données numériques, qui correspondent au signal d'entrée (ES), respectivement par un facteur défini (F) qui est égal au facteur d'amplification défini (V),
b) en rapport avec le signal préparé (AS), il vérifie des données correspondantes pour savoir s'il existe un dépassement de la gamme dynamique associée, et
c) qu'il détermine les résultats de la conversion analogique/numérique en utilisant les données numériques qui correspondent au signal préparé (AS), tant que le signal préparé (AS) est situé à l'intérieur de la gamme dynamique, et sans tenir compte des données numériques qui correspondent au signal préparé (AS), moyennant l'utilisation des données qui correspondent au signal d'entrée (ES) et sont multipliées par le facteur défini (F), tant qu'un dépassement de la gamme dynamique est présent en rapport avec le signal préparé (AS).

13. Dispositif suivant la revendication 12, caractérisé par le fait que les moyens (10, 11) servant à former le signal préparé (AS) appliquent, comme première fonction de transfert (T1), la fonction de transfert d'un filtre passe-haut au signal d'entrée (ES).

14. Dispositif suivant la revendication 12 ou 13, caractérisé par le fait que le dispositif de calcul (6) est agencé de telle sorte qu'il applique aux données numériques correspondant au signal d'entrée (ES), avant leur utilisation pour déterminer les résultats de la conversion analogique/numérique, une seconde fonction de transfert (T2), au moyen d'un filtrage numérique.

15. Dispositif suivant la revendication 14, caractérisé par le fait que l'unité de calcul électronique (6) est agencée de telle sorte qu'elle applique la fonction de transfert d'un filtre passe-haut aux données numériques qui correspondent au signal d'entrée (ES).

16. Dispositif suivant l'une des revendications 12 à 15, caractérisé par le fait que le dispositif de calcul électronique (6) est agencé de telle sorte que tant que le signal préparé (AS) est situé à l'intérieur de la gamme dynamique, ce dispositif détermine les résultats de la conversion analogique/numérique en utilisant les données numériques qui correspondent au signal d'entrée (ES) et sont multipliées par le facteur défini (F), et applique au préalable une troisième fonction de transfert (T3) à ces données, au moyen d'un filtrage numérique.

17. Dispositif suivant la revendication 16, caractérisé par le fait que le dispositif de calcul électronique (6) est agencé de telle sorte qu'il applique en tant que troisième fonction de transfert (T3), le complément complexe de la première fonction de transfert (T1) aux données numériques qui correspondent au signal d'entrée (ES) et sont multipliées par le facteur défini (F), et qu'il utilise des données numériques qui correspondent au signal d'entrée (ES) pour la détermination des résultats de la conversion analogique/numérique, de telle sorte qu'il forme les sommes des données numériques obtenues par filtrage numérique du signal d'entrée (ES), et des données numériques qui correspondent au signal préparé (AS).

18. Dispositif suivant l'une des revendications 12 à 17, caractérisé par le fait que le dispositif de calcul électronique (6) est agencé de telle sorte qu'il forme, pour des échantillons successifs dans le temps, la différence entre les données numériques, qui correspondent au signal d'entrée (ES) et sont multipliées par le facteur défini (F), et les données numériques qui correspondent au signal préparé (AS) et utilise une différence ainsi obtenue pour corriger les erreurs d'offset.

19. Dispositif suivant la revendication 18, caractérisé par le fait que le dispositif de calcul électronique (6) est agencé de telle sorte qu'il forme la valeur moyenne à partir des différences, déterminées pour un nombre défini d'échantillons successifs, en tenant compte de leurs signes et qu'il utilise cette valeur moyenne pour corriger des erreurs d'offset.

20. Dispositif suivant l'une des revendications 12 à 19, caractérisé par le fait qu'il est prévu des moyens (13) pour produire un signal analogique (PS), qui produisent un signal analogique (PS), dont l'amplitude maximale est au moins égale à celle de la différence de tension, qui correspond à un bit de poids inférieur (LSB) lors de la conversion analogique/numérique du signal d'entrée (ES), qui possède une distribution d'amplitudes, statistiquement uniforme, qu'il est prévu des moyens (14, 15, 16, 17) pour superposer un signal d'entrée (ES) au signal périodique (PS), et que le dispositif de calcul électronique (6) est agencé de telle sorte qu'il applique par filtrage numérique une quatrième fonction de transfert aux données de sortie, qui correspondent au signal résultant de la superposition du signal d'entrée (ES) et du signal analogique (PS), aux moyens (4,9,12) servant à réaliser la conversion analogique/numérique, cette fonction de transfert ayant un effet d'intégration, et qu'il utilise les données numériques ainsi obtenues en tant que données numériques correspondant au signal d'entrée (ES).

21. Dispositif suivant la revendication 20, caractérisé par le fait que le dispositif de calcul électronique (6) est agencé de telle sorte qu'il applique, en tant que quatrième fonction de transfert, la fonction de transfert d'un filtre passe-bas aux données numériques correspondant au signal résultant.

22. Dispositif suivant la revendication 20 ou 21, caractérisé par le fait que les moyens (13) servant à produire un signal analogique (PS), produisent un signal périodique.

23. Dispositif suivant l'une des revendications 12 à 22, caractérisé par le fait que pour l'étalonnage
a) un signal analogique de tension alternative (PS) est superposé au signal d'entrée (ES) avant la formation du signal préparé (AS), et
b) tant que le signal préparé (AS) est situé à l'intérieur de la gamme dynamique, pour les différents échantillons, une comparaison est réalisée entre les résultats déterminés en utilisant les données numériques qui correspondent au signal préparé (AS), de la conversion analogique/numérique avec les résultats de la conversion analogique/numérique déterminés sans tenir compte des données numériques correspondant au signal préparé (AS) et en utilisant les données numériques qui correspondent au signal d'entrée (ES) et sont multipliées par le facteur défini (F).

24. Dispositif suivant la revendication 23, caractérisé par le fait que les résultats de la comparaison sont utilisés pour réaliser une correction d'erreurs.

25. Dispositif suivant la revendication 23 ou 24 pour l'étalonnage du dispositif suivant l'une des revendications 20 à 22, caractérisé par le fait qu'on superpose le signal produit à l'aide des moyens (13) servant à produire un signal analogique (PS), au signal d'entrée (ES).

26. Dispositif suivant l'une des revendications 23 à 25, caractérisé par le fait que pendant le processus d'étalonnage, le signal d'entrée (ES) possède la valeur nulle.
